# EUROPEAN PATENT APPLICATION

(11) **EP 4 440 252 A1**
(43) Date of publication of application: **02.10.2024**
(21) Application number: 23166034.1
(22) Date of filing: 31.03.2023
(51) Int. Cl.: H05K 3/26, H05K 1/11

(54) **METHOD FOR REMOVING AN ORGANIC RESIN FROM A SURFACE OF A SUBSTRATE**

(71) Applicant: Atotech Deutschland GmbH & Co. KG, 10553 Berlin (DE)
(72) Inventor: Giles, Keith, 10553 Berlin (DE); Rousseau, Agnes, 10553 Berlin (DE); Gregoriades, Laurence John, 10553 Berlin (DE); Lamprecht, Sven, 10553 Berlin (DE)
(74) Representative: MKS IP Association

(57) **Abstract**

The present invention relates to a method for removing an organic resin from a copper surface onto a dielectric substrate comprising conductive through holes (THs) and/or conductive blind micro vias (BMVs), the method comprising the following steps:
(i) applying an organic paste to the dielectric substrate, in order to fill up the through holes (THs) and/or blind micro vias (BMVs) with the organic paste, wherein after step (i) at least a part of the surface of the dielectric substrate is covered by the organic paste;
(ii) curing the organic paste to transfer the organic paste into solidified organic resin, wherein after step (ii) at least a part of the surface of the dielectric substrate is covered by the organic resin;
(iii) chemical treating the dielectric substrate with a non-aqueous composition to remove the organic resin from the surface of the substrate, in order to obtain a chemical treated surface of the substrate, the non-aqueous composition comprising:
a) at least one high-boiling solvent at a concentration from 80 % by weight to 95 % by weight wherein the high-boiling solvent has a boiling point of at least 100 °C,
b) at least one carboxylic acid at a concentration from 5 % by weight to less than 20 % by weight,
c) at least one anionic aromatic surfactant at a concentration from 0.25 % by weight to less than 1.5 % by weight, and
d) at least one non-ionic acetylenic diol - based surfactant at a concentration from 0.25 % by weight to less than 1.5 % by weight;

(iv-1) mechanically treating the chemical treated surface of the substrate obtained after step (iii) with an abrasion tool to remove remaining organic resin from the chemical treated surface of the substrate, in order to obtain a mechanically treated surface of the substrate; and/or
(iv-2) wet-chemical treating the chemical treated surface of the substrate obtained after step (iii) with an oxidizing solution comprising an oxidizing agent to remove remaining organic resin from the chemical treated surface of the substrate to obtain a wet-chemical treated surface of the substrate;
(v) optionally deposition of a conductive material, preferably electroless deposition of a coating metal, on the mechanically treated surface obtained after step (iv-1) or the wet-chemical treated surface of the substrate obtained after step (iv-2), to obtain a conductive surface of the substrate; and
(vi) optionally electrolytic deposition of an additional coating metal on the conductive surface of the substrate obtained after optional step (v) or on the mechanically treated surface of the substrate obtained after step (iv-1) or on the wet-chemical treated surface of the substrate after step (iv-2) in order to obtain an electrolytic metal coated surface.

## Description

### Field of the Invention

The present invention according relates to a method for removing an organic resin from a copper surface onto a dielectric substrate comprising conductive through holes (THs) and/or conductive blind micro vias (BMVs) and to an article with a metal coated surface obtained by the method. The method in particular is suitable for the manufacturing of an article comprising VIPPO (via-in-pad-plated over) structures. The present invention is further directed to a use of the non-aqueous composition for removing an organic resin from a surface of said dielectric substrate.

### Background of the Invention

The removal of organic coatings as paints from metallic surfaces as steel or aluminum surfaces is known in the automotive industry.

In US 3,790,489 A a paint stripping compound is described to be used at elevated temperatures which has a caustic base of an alkali metal hydroxide, an alkali metal nitrate, an alkali metal chloride, a catalyst selected from the group of alkali metal permanganates, manganese dioxide and Cr₂O₃, and preferably an alkali metal carbonate. The components are fused and maintained at a temperature between 800 °F (about 426 °C) and 900 °F (about 482 °C) for removal.

However, certain metals, such as zinc, aluminum and magnesium or metallic coatings comprised of metals or alloys thereof, as well as other metals, alloys, and even non-metallic substrates, are subject to chemical attack or destruction under such conditions as taught in US 3,790,489 A. Thus, such caustic compositions are typically avoided in prior art teachings when removing coatings from metals, such as from aluminum, magnesium and zinc.

One prior art approach which is based on high boiling point glycol in a stripping composition is taught by WO 2017/194449 A1, wherein stripping from the substrate is achieved by using a non-aqueous stripping composition and a method of stripping an organic coating from a substrate.

However, the removal of organic resins from substrates is also extremely important in the electronic industry. In particular, organic resins or residues e.g. on the copper surface need to be removed from dielectric substrates in order to avoid that the resin functions as "etch resist" which finally leads to shorts and opens in the circuitry, in particular during the manufacturing process of printed circuit boards (PCBs).

Therefore, there is a growing demand for effective removal of organic resins in the manufacturing process of printed circuit boards (PCBs). In particular in respect to increasing signal speeds and advanced FC-BGA pitch density, the focus in respect to PCB design shifts towards the use of via-in pad plated over (VIPPOs), thereby replacing more and more traditional dog-bone-pad structures used in conventional PCBs, which allows for a shrinkage of the signal path length thereby reducing the capacitance and the inductance.

Typically for a VIPPO design, the manufactured PCB after a process sequence of: drilling of recesses as through holes and blind micro vias, desmear, activation, electroless copper deposition, and electrolytic copper deposition, is typically screen-printed with a specially designed plugging paste to completely fill all plated through holes and blind micro vias with that paste. During the screen-printing process, a thin film of resin is smeared over the PCB surface and hardened during a subsequent curing step. However, this thin film of resin needs to be removed for further processing to build the VIPPOs. Therein, it has to be ensured that all plugging paste is removed from the PCB surface to provide subsequent high reliable metal deposits with excellent adhesion and conductivity.

This removing is done by mechanical grinding on the resin-smeared PCB surface. Typically, a grinding machine is used for grinding the surface to remove excess plugging paste from PCB surface after the via hole filling process. The material of the grinding head can be e.g. silicon carbide. Additionally, water can be used during grinding. The pressure of the grinding head onto the surface has to be carefully adjusted to minimizes the risk of potentially grinding through the copper foil.

### Objectives of the present invention

It was therefore the first objective of the present invention to overcome the shortcomings of the prior art and to provide means for improved removal of organic resin, i.e., cured organic filler paste, from a copper surface of a wide variety of dielectric substrates, which comprise through holes (THs) and/or blind micro vias (BMVs).

It was therefore the second objective of the present invention to provide surface treatment for a wide variety of dielectric substrates to avoid damaging of copper surface of the substrate, in particular avoiding of partly removing or weakening of the adhesion of the copper surface onto the substrate.

It was therefore the third objective of the present invention to provide surface treatment for a wide variety of organic resin, which allows for a metal coating on the respective substrate, which has an excellent adhesion strength, in particular of the electrolytical deposited copper coating and is difficult to be peeled off, in particular over blind micro vias (BMVs) and/or over through holes (TH) of the substrate.

It was therefore the fourth objective of the present invention to provide surface treatment for a wide variety of dielectric substrates, which can be included into a conventional process sequence for the manufacturing of an article comprising VIPPO (via-in-pad-plated over) structures, for example in vertical and/or horizontal processes, without major amendments to other process steps, in order to reduce manufacturing costs.

### Summary of the Invention

The first to fourth objectives mentioned above are solved according to a first aspect of the invention by a method for removing an organic resin from a copper surface onto a dielectric substrate comprising conductive through holes (THs) and/or conductive blind micro vias (BMVs), the method comprising the following steps:
(i) applying an organic paste to the dielectric substrate, in order to fill up the through holes (THs) and/or blind micro vias (BMVs) with the organic paste, wherein after step (i) at least a part of the surface of the dielectric substrate is covered by the organic paste;
(ii) curing the organic paste to transfer the organic paste into solidified organic resin, wherein after step (ii) at least a part of the surface of the dielectric substrate is covered by the organic resin;
(iii) chemical treating the dielectric substrate with a non-aqueous composition to remove the organic resin from the surface of the substrate, in order to obtain a chemical treated surface of the substrate, the non-aqueous composition comprising or consisting of:
   a) at least one high-boiling solvent at a concentration from 80 % by weight to 95 % by weight, preferred at a concentration from 81 wt.-% to 91 wt.-%, selected from the group, consisting of alcohols having general chemical formula R-OH, wherein R is a C₄-C₃₀ hydrocarbon group, wherein the high-boiling solvent has a boiling point of at least 100 °C,
   b) at least one carboxylic acid at a concentration from 5 % by weight to less than 20 % by weight, preferred at a concentration from 4 % by weight to 9 % by weight, more preferred from 7 % by weight to 8 % by weight, preferably the at least one carboxylic acid is at least one hydroxy carboxylic acid, more preferably is selected from the group consisting of 2-hydroxy-propionic acid, tartaric acid and glycolic acid,
   c) at least one anionic aromatic surfactant at a concentration from 0.25 % by weight to less than 1.5 % by weight, preferred at a concentration from 0.5 % by weight to 1 % by weight, preferably the at least one anionic aromatic surfactant is selected from the group consisting of at least one c10-c16-alkylbenzene sulfonic acid and toluene-sulfonic acid, and
   d) at least one non-ionic acetylenic diol - based surfactant at a concentration from 0.25 % by weight to less than 1.5 % by weight, preferred at a concentration from 0.5 % by weight to 1 % by weight, preferably selected from the group consisting of at least one c8-c12 alkyne-diol, more preferably is 2,4,7,9-tetramethyldec-5-yne-4,7-diol;
(iv-1) mechanically treating the chemical treated surface of the substrate obtained after step (iii) with an abrasion tool to remove remaining organic resin from the chemical treated surface of the substrate, in order to obtain a mechanically treated surface of the substrate; and/or
(iv-2) wet-chemical treating the chemical treated surface of the substrate obtained after step (iii) with an oxidizing solution comprising an oxidizing agent to remove remaining organic resin from the chemical treated surface of the substrate to obtain a wet-chemical treated surface of the substrate;
(v) optionally deposition of a conductive material, preferably electroless deposition of a coating metal, on the mechanically treated surface obtained after step (iv-1) or on the wet-chemical treated surface of the substrate obtained after step (iv-2), to obtain a conductive surface of the substrate;
(vi) optionally electrolytic deposition of an additional coating metal on the conductive surface of the substrate obtained after optional step (v) or on the mechanically treated surface of the substrate obtained after step (iv-1) or on the wet-chemical treated surface of the substrate after step (iv-2) in order to obtain an electrolytic metal coated surface; and
(vii) optionally structuring the electrolytic metal coated surface of step (vi) and electrolytic deposition of a solder pad, preferably tin solder pad, in order to obtain VIPPO (via-in-pad-plated over) structures.

The quantity of all constituents of the non-aqueous composition above and optionally added constituents adding up to 100 % by weight (wt. %) of the composition or with other words the sum of all constituents does not exceed the total of 100 % by weight.

The method removes excess organic resin and remaining uncured organic paste (plugging paste) from the surface of the substrate, in particular from a copper surface of a printed circuit board while the organic resin within the conductive through holes (THs) and/or conductive blind micro vias (BMVs remains.

The method, in particular the mechanical treatment according to step (iv-1) and/or the wet-chemical treatment according to step (iv-2) allows for an efficient removal of loosely or weakly attached surface resin from the substrate, in particular in proximity to through holes (TH) and/or blind micro vias (BMV) of the dielectric substrate.

Therefore, the method steps (iv-1) and/or (iv-2) ensure that after the previous chemical treatment of the dielectric substrate with the non-aqueous composition during method step (iii), the organic resin is completely removed from the surface of the dielectric substrate to allow for a superior subsequent deposition of conductive materials during step (v) and/or of coating metal during step (vi). Preferably, applying step (iv-1) or step(iv-2) only is sufficient to complete cleaning after applying step (iii).

The method avoids damaging the surface of the dielectric substrate, the copper surface and/or the non-conductive surface of the PCB due to grinding. The method preferably excludes a grinding step using grinding devices.

By performing the optional deposition of a conductive material, preferably electroless deposition of a coating metal, on the mechanically treated surface obtained after step (iv-1) or the wet-chemical treated surface of the substrate obtained after step (iv-2), an effective activation layer is deposited onto the respective treated surface which allows for a subsequent optionally electrolytic deposition of an additional coating metal on the conductive surface of the substrate.

Further, due to the high efficiency of the treatment steps (iii), and (iv-1) or (iv-2), the treatment of wastewater can be simplified, the energy and time consumption can be reduced, and consequently the manufacturing costs can be reduced in view of prior art treatment steps.

The first to fourth objectives mentioned above are solved according to a second aspect by an article with a metal coated surface obtained by a method according to the first aspect.

Said article comprises an excellent metal coating according to the advantages summarized before.

The first to fourth objectives mentioned above are solved according to a third aspect by a use of the non-aqueous composition according to the method of the first aspect for removing an organic resin from a surface of a dielectric substrate comprising through holes (THs) and/or blind micro vias (BMVs) for the manufacturing of an article comprising VIPPO (via-in-pad-plated over) structures.

### Brief description of the Example

In the Example, samples 1, 2, and 3 are examined in respect to variations of the chemical treatment steps of the respective substrate surfaces in respect to the resulting optical properties of nickel-plated surfaces obtained afterwards.

Further details are given in the "Example" section below in the text.

### Detailed Description of the Invention

### General definitions

In the context of the present invention, the term "at least one" or "one or more" denotes (and is exchangeable with) "one, two, three or more than three".

In the context of the present invention, the term "and/or" includes any and all combinations of one or more of the associated listed items.

In the context of the present invention, the terms "deposition", "coating" and "plating" are used interchangeably herein. In the context of the present invention, the terms "layer", "coating" and "deposit" are used interchangeably herein.

In the context of the present invention, the term "dielectric" means non-metallic and thereby nonconductive.

In the context of the present invention, the term "aqueous solution" means that aqueous solution comprises water of 50 weight-% (wt.-%) or more.

In the context of the present invention, the term "desmear process" means a wet-chemical process performed after drilling of THs and BMVs, which relates in particular to a process for the removal of residues as particulates generated by laser drilling or mechanical drilling into the surface of the dielectric substrate to form through holes (THs, also named through hole vias (THVs)) and/or blind micro vias (BMVs) in the substrate. The wet-chemical process comprises at least an etching agent, preferably using aqueous acidic or alkaline permanganate solution.

In the context of the present invention, a copper surface of the dielectric substrate to be treated is understood as a copper surface of a copper layer which is deposited onto the dielectric substrate wherein the substrate comprises through-holes (THs) and blind micro vias (BMVs).

"conductive" in conductive through holes (THs) and conductive blind micro vias (BMVs) means that the copper layer is also deposited onto the wall of the THs and BMVs building said conductive through holes (THs) and conductive blind micro vias (BMVs). The copper layer is conformal deposited and the THs and BMVs are not filled with copper.

In the context of the present invention, the term `alkyl' refers to a saturated linear or branched-chain monovalent hydrocarbon radical having 1 to 18 carbon atoms (C₁-C₁₈), wherein the alkyl group may optionally be substituted independently with one or more substituents described hereinafter. Examples of alkyl groups include, but are not limited to, methyl, ethyl, propyl, butyl, pentyl, hexyl, heptyl, octyl, nonyl, decyl, undecyl, dodecyl and the higher homologs thereof, while including all isomers thereof.

In the context of the present invention, the term 'alkyne' (also alkinyl) refers to a non-saturated linear or branched-chain monovalent hydrocarbon radical having at least one triple bond and having 8 to 12 carbon atoms (C₂-C₃₀), wherein the alkyne group may optionally be substituted independently with one or more substituents described hereinafter. Examples of alkyne groups include, but are not limited to oct-4-yne, dec-5-yne or dodec-6-yne and the like.

In the context of the present invention, the term 'aromatic' refers to a monovalent aromatic hydrocarbon radical having 6 to 20 carbon atoms (C₆-C₂₀) derived by the removal of one hydrogen atom from a single carbon atom of a parent aromatic ring system as an aryl. Aryl also includes a bicyclic radical comprising an aromatic ring fused to an aromatic carbocyclic ring. Typical aryl groups include, but are not limited to, radicals derived from benzene (phenyl), substituted benzenes, naphthalene and the like. Aryl groups are optionally substituted independently with one or more substituents described herein below.

Alkyl, alkinyl and aryl may each be substituted, wherein at least one hydrogen atom thereof may be substituted by halogen atoms.

In the context of the present invention, the term 'hydrocarbon group' refers to a chemical group having a linear or branched-chain backbone which exclusively consists of carbon atoms wherein two neighboring carbon atoms are bonded together via a single bond or double bond or triple bond or are members of an aromatic ring, wherein this backbone further includes hydrogen atoms bonded to the carbon atoms. These hydrogen atoms may in part be substituted by halogen atoms thus forming part of the hydrocarbon group. The hydrocarbon group does not include hydroxy groups. More preferably, a hydrocarbon group may be a linear or branched-chain alkyl, a linear or branched-chain alkenyl, a linear or branched-chain alkyne, a cycloalkyl, or a cycloalkenyl, including bicyclic, tricyclic and higher condensed alicyclic groups. These compounds are aliphatic hydrocarbon groups. Furthermore, a hydrocarbon group may preferably be an aryl, an arylalkylene, an arylalkenylene, an arylalkinylene, an arylcycloalkylene, or an arylcycloalkenylene, including bicyclic, tricyclic and higher condensed aryl groups, wherein alkylene in arylalkylene, alkenylene in arylalkenylene and alkinylene in arylalkinylene are linear or branched-chain groups as before and wherein cycloalkylene in arylcycloalkylene and cycloalkenylene in arylcycloalkenylene may form higher condensed alicyclic ring systems. In these latter cases the bifunctional groups present one bond to the OH group of the high-boiling alcohol. Hydrocarbon groups which are arylalkylene, arylalkenylene, arylalkinylene, arylcycloalkylene, or arylcycloalkenylene are araliphatic groups. In these latter cases, the bifunctional groups present one bond to the OH group of the high-boiling alcohol. The hydrogen atoms bonded to the cycloalkyl, cycloalkylene, cycloalkenyl, cycloalkenylene, and aryl groups may in part be substituted by halogen atoms, further by alkyl, by alkenyl, and/or by alkinyl groups. More specifically, the term 'C₄-C₃₀ hydrocarbon group' as used herein refers to a group having a backbone comprising 4 to 30 carbon atoms including all backbone carbon atoms comprised in the alkyl, alkenyl, and/or alkinyl groups which substitute hydrogen atoms on the cycloalkyl, cycloalkylene, cycloalkenyl, cycloalkenylene, and aryl groups. Even more specifically, the term 'C₄-C₂₀ hydrocarbon group' as used herein refers to a group having a backbone comprising 4 to 20 carbon atoms including all backbone carbon atoms as described herein before. Likewise, the term 'C₄-C₁₀ hydrocarbon group' as used herein refers to a group having a backbone comprising 4 to 10 carbon atoms including all backbone carbon atoms as described herein before. Accordingly, the term 'C₁-C₂₀ hydrocarbon group' as used herein refers to a group having a backbone comprising 1 to 20 carbon atoms including the backbone carbon atoms as described before. As far as in the meaning of the term 'C₁-C₂₀ hydrocarbon group' a group is referred to, which has one carbon atom only ('C₁ hydrocarbon group'), this group is methyl; and as far as in the meaning of the term 'C₁-C₂₀ hydrocarbon group' a group is referred to, which has two carbon atoms ('C₂ hydrocarbon group'), this group is ethyl, ethenyl or ethinyl.

In the context of the present invention, the term 'about' in connection with concentration values (% by weight or wt.-%) or temperature values or treatment time values or thickness values means the exact (mean) value given as well as a range of concentration values or temperature values or treatment time values or thickness values which is ± 30 % relative to this mean value. For example, 'about 3 % by weight' means exactly 3 % by weight and a range from 3 % by weight - 30 % of 3 % by weight (= 3 % by weight - 0.9 % by weight = 2.1 % by weight) to 3 % by weight + 30 % of 3 % by weight (= 3 % by weight + 0.9 % by weight = 3.9 % by weight), thus yielding a range of from 2.1 % by weight to 3.9 % by weight. The value ranges defined with 'about' given for the operating temperature or treatment time or thickness are correspondingly understood, with the relative percentage for the temperature values being based in the °C scale (± 30 % of 40 °C is ± 12 °C).

### First aspect

The present invention according to the first aspect is directed to a method for removing an organic resin from a copper surface onto a dielectric substrate comprising conductive through holes (THs) and/or conductive blind micro vias (BMVs), the method comprising the following steps:
(i) applying an organic paste to the dielectric substrate, in order to fill up the through holes (THs) and/or blind micro vias (BMVs) with the organic paste, wherein after step (i) at least a part of the surface of the dielectric substrate is covered by the organic paste;
(ii) curing the organic paste to transfer the organic paste into solidified organic resin, wherein after step (ii) at least a part of the surface of the dielectric substrate is covered by the organic resin;
(iii) chemical treating the dielectric substrate with a non-aqueous composition to remove the organic resin from the surface of the substrate, in order to obtain a chemical treated surface of the substrate, the non-aqueous composition comprising:
   a) at least one high-boiling solvent at a concentration from 80 % by weight to 95 % by weight, preferred at a concentration from 81 wt.-% to 91 wt.-%, selected from the group, consisting of alcohols having general chemical formula R-OH, wherein R is a C₄-C₃₀ hydrocarbon group, wherein the high-boiling solvent has a boiling point of at least 100 °C;
   b) at least one carboxylic acid at a concentration from 5 % by weight to and 20 % by weight, preferred at a concentration from 4 % by weight to 9 % by weight, more preferred from 7 % by weight to 8 % by weight, preferably the at least one carboxylic acid is at least one alpha-hydroxy carboxylic acid, more preferably is 2-hydroxy-propionic acid ;
   c) at least one anionic aromatic surfactant at a concentration from 0.25 % by weight to less than 1.5 % by weight, preferred at a concentration from 0.5 % by weight to 1 % by weight, preferably selected from the group consisting of at least one c10-c16-alkylbenzene sulfonic acid; and
   d) at least one non-ionic acetylenic diol - based surfactant at a concentration from 0.25 % by weight to less than 1.5 % by weight, preferred at a concentration from 0.5 % by weight to 1 % by weight, preferably selected from the group consisting of at least one c8-c12 alkyne-diol, more preferably is 2,4,7,9-tetramethyldec-5-yne-4,7-diol.
(iv-1) mechanically treating the chemical treated surface of the substrate obtained after step (iii) with an abrasion tool to remove remaining organic resin from the chemical treated surface of the substrate, in order to obtain a mechanically treated surface of the substrate, and/or
(iv-2) wet-chemical treating the chemical treated surface of the substrate obtained after step (iii) with an oxidizing solution comprising an oxidizing agent to remove remaining organic resin from the chemical treated surface of the substrate to obtain a wet-chemical treated surface of the substrate;
(v) optionally deposition of a conductive material, preferably electroless deposition of a coating metal, on the mechanically treated surface obtained after step (iv-1) or the wet-chemical treated surface of the substrate obtained after step (iv-2), to obtain a conductive surface of the substrate;
(vi) optionally electrolytic deposition of an additional coating metal on the conductive surface of the substrate obtained after optional step (v) or on the mechanically treated surface of the substrate obtained after step (iv-1) or on the wet-chemical treated surface of the substrate after step (iv-2) in order to obtain an electrolytic metal coated surface; and
(vii) optionally structuring the electrolytic metal coated surface of step (vi) and electrolytic deposition of a solder pad, preferably tin solder pad, in order to obtain VIPPO (via-in-pad-plated over) structures.

It was found that the method steps according to the present invention lead to more effective and at the same time more gentle removal of organic resin, in particular organic epoxy resin, from the respective substrate, which allows for an particularly effectively cleaned surface, onto which further electroless deposition of a conductive material and/or electrolytic deposition of an additional coating metal can be achieved. In particular not only the adhesion of the deposited conductive material and/or deposited additional coating metal onto the copper surface, also the adhesion of said deposited conductive material and/or deposited additional coating metal onto the organic resin of the filled THs and BMVs is significantly improved.

### Steps (i) and (ii)

Preferably, the organic paste applied during step (i) comprises epoxy paste, polyester paste, polyurethane paste and acrylic paste, wherein more preferably the organic paste applied during step (i) comprises an epoxy paste used for subsequent VIPPO applications. Preferably an epoxy paste basing on Bisphenol A with a molecular weight (MW) of 700 or lower can be used and be derived from e.g. Taiyo America, Inc. 2675 Antler Drive, Carson City, NV 89701, e.g. as THP-100DX1 products.

Preferably, the curing of the organic paste performed during step (ii) in order to obtain the solidified organic resin includes a thermal curing process, which more preferably is performed between 130 °C and 160 °C, most preferably at 150°C.

Preferably, the curing of the organic paste performed during step (ii) is performed for a duration between 30 minutes and 60 minutes, preferably for 45 minutes.

The solidified organic resin derived from the organic paste material after curing is preferably chemically different from the material of the dielectric substrate. That means, only the solidified organic resin can be removed in treatment step (iii) from the dielectric substrate while the dielectric substrate is chemical inert (is not removable) over the treatment step (iii).

### Step (iii)

Accordingly, the non-aqueous composition of the present invention as used in method step (iii) comprises four key components and optionally further components, these key components being: a) - d) as explained above.

By using the non-aqueous composition, a very efficient removal of the solidified organic resin from the surface of the substrate is achieved even at low operating temperature. This is believed to be due to the combination of the solvent and the carboxylic acid together with the selected surfactants bringing about its strongest effect on dissolution and removal of polymer resins, which might further help to improve rinsing of the substrate afterwards due to its good miscibility with water.

One further advantage of the present invention is that preferred surfactant levels are lower than those found in prior art strippers. Moreover, if low foaming surfactants or proper blending of low HLB and high HLB surfactants are used in the present invention, the surfactants additionally help the rinsing off the non-aqueous solution from the treated parts and at the same time, they also control the foaming issues in the subsequent rinsing step. Thus, there is no real foaming problem arising, defoaming agents or other counter measures are not required. Thereby efficiencies of the removal process along with its cost-effectiveness may be improved.

Due to the aggressiveness and efficiency of removal of the organic resin from the substrate, it is possible to reduce the operating temperature during method step (iii) as compared to the operating temperature which is reported to be necessary for efficient stripping in US 7,151,080 B2 for example, wherein the operating temperature is well above 100 °C. The operating temperature may considerably be reduced to a lower value, from 30 °C and 90 °C, more preferably to between 60 °C and 85 °C, for example. Likewise, treatment time of method step (iii) may be reduced as compared to conventional methods because the non-aqueous composition is much more efficient than prior art compositions. This is due to the combination of the solvent and the co-solvent as compared to the prior art compositions.

The non-aqueous composition aggressively and effectively removes the organic resin from the respective substrates without harming the underlying substrates damaged by prior art strippers, over conventional or lower treatment time periods, and at conventional or lower temperatures.

The non-aqueous composition is further made up of components which are stable under the working conditions, especially at the operating temperature needed to effectively remove the organic resin. Moreover, the non-aqueous composition fulfills the requirements of safety of the staff working with it.

The composition used according to method step (iii) of the present invention is non-aqueous, which means that the non-aqueous composition is essentially free of water. Some water intake may occur during operation of the procedure from the atmosphere. Preferably, no water is purposely added to the non-aqueous composition. Generally, the water content in the non-aqueous composition also during operation shall be less than 1 % by weight, preferably less than 0.5 % by weight, more preferably less than 0.1 % by weight and most preferably less than 0.01 % by weight. Water contained in the non-aqueous composition does not negatively affect the removal performance. But, when water is present in the non-aqueous composition, the composition usually tends to exhibit chemical attack on soft metals, like aluminum, zinc and magnesium. Such chemical attack is believed to be due to ionization of the acid compound or hydroxide compound present in the non-aqueous composition, so that the ions produced due to this ionization can etch these metals. Therefore, by dispensing with water from adding same to the non-aqueous composition, the present invention is appropriate for use on sensitive substrates. Thus, as used herein, the term `essentially free of water' means a water content at a level which will not ionize the potassium hydroxide or acid component to such an extent that it will attack aluminum, magnesium or zinc substrates.

The high-boiling solvents which may be used in the non-aqueous composition of the present invention may be selected from a variety of different high-boiling alcohols, specifically from those high-boiling alcohols having general chemical formula R-OH the boiling points of which are suitable with an operating temperature of for example 30 °C to 90 °C. More preferably, the non-aqueous composition according to the present invention is operated at a temperature in a range of from 60 °C to 90 °C, most preferably from 65 °C to 85 °C, wherein a temperature being set at a higher value within this range is suitable to remove resins.. Therefore, according to the present invention, the boiling point of the at least one high-boiling alcohol will be at least 100 °C. It may be as high as 200 °C or 300 °C or even higher, its highest value being limited by the energy being afforded by heating the non-aqueous composition and by the thermal stability of the substrate material.

According to a preferred embodiment of the present invention, the non-aqueous composition comprises at least one high-boiling solvent which is a compound having the general chemical formula R-OH, wherein R is arylalkylene, wherein aryl is preferably a C₆-C₁₀ aryl and wherein alkylene is preferably a C₁-C₆ alkylene.

According to an even more preferred embodiment of the present invention, the non-aqueous composition comprises at least one high-boiling solvent which is benzyl alcohol (C₆H₅-CH₂-OH) or another phenylalkylene compound, as good removal performance has proved to be obtained with benzyl alcohol based non-aqueous compositions.

In a most general way of description of the invention as describe above for the chemical treatment step, the non-aqueous composition contains four key components. In a preferred embodiment, these key components are combined within specified relative proportions: In a preferred embodiment of the present invention, the non-aqueous composition may comprise or consist of:
a) from 81 % by weight to 95 % by weight, of the at least one high-boiling solvent;
b) from 5 % by weight to 20 % by weight, of the at least one carboxylic acid, preferably at least one hydroxy carboxylic acid;
c) at least one anionic aromatic surfactant at a concentration from 0.25 % by weight to 1.5 % by weight, preferably at least one c10-c16-alkylbenzene sulfonic acid; and
d) at least one non-ionic acetylenic diol - based surfactant at a concentration from 0.25 % by weight to 1.5 % by weight, preferably at least one c8-c12 alkyne-diol,
wherein the components make up for 100 % by weight of the non-aqueous composition. If the non-aqueous composition contains more than one compound of the respective components a, b, c and d, the concentrations given herein before denoting the overall concentration of all compounds of the respective one of these components.

If the non-aqueous composition contains even further components in addition to components a, b, c, d above, the respective percentage will be adjusted accordingly.

In another preferred embodiment of the present invention, the non-aqueous composition further comprises or consists of the components as follows:
a) 90 % by weight, of the at least one high-boiling solvent, preferably of benzyl alcohol;
b) 8 % by weight, of the at least one alpha-hydroxy carboxylic acid, preferably of 2-hydroxy-propionic acid;
c) 1 % by weight, of at least one c10-c16-alkylbenzene sulfonic acid; and
d) 1 % by weight, of at least one c8-c12 alkyne-diol, preferably of 2,4,7,9-tetramethyldec-5-yne-4, 7 -diol.

The components a, b, c and d make up for 100 % by weight of the non-aqueous composition.

The operating temperature of method step (iii) may be set to at least about 30 °C, preferably at least about 40 °C, more preferably to at least about 60 °C and even more preferably to at least about 65 °C. Furthermore, the operating temperature of method step (iii) may be set to at most about 150 °C or even higher, more preferably to at most about 90 °C and even more preferably to at most about 85 °C, most preferably at 80°C. According to an even more preferred embodiment of the present invention, the operating temperature of method step (iii) is from about 65 °C to about 85 °C.

Most preferably, step (iii) is performed at a temperature from 60°C to 90°, even most preferably from 65°C to 85°C, most preferably at 80°C.

Preferably, step (iii) is performed for a duration from 1 minute to 15 minutes, more preferably from 2 to 5 minute.

Normally removed resin material stays in the non-aqueous composition and accumulates in the non-aqueous bath over time. If partially removed parts still having patches of resin these are transferred to a rinse bath, so that these resins may be removed in this rinse step. In this case, it is possible to reduce the rate of resin accumulation in the non-aqueous bath and to advantageously extend the bath life.

The non-aqueous composition may also be sprayed onto the substrate surface to be removed. It may be used in combination with an immersion soak, either preceded or followed by spray application, or both.

A preferred mode of operation to remove resins from a substrate comprises the following sub-steps of method step (iii):
iii-a) providing the non-aqueous composition of the present invention in a tank device;
iii-b) bringing the substrate into contact with the non-aqueous composition in the tank device in order to remove the organic resin;
iii-d) completely removing the organic resin from the substrate by applying a high-pressure water spray to the substrate surface.

The high-pressure water spray applied in step iii-d. generally has a pressure of from 5 bar to 250 bar.

The non-aqueous composition is heated in step iii-a) and/or in step iii-b), preferably in step iii-b) to a temperature of from 30 °C to 90 °C, preferably 65 °C to 85 °C for a period of time from 1 min to 15 min and thereby removing or loosening the resin from the substrate.

### Step (iv-1) or step (iv-2)

Additional method steps (iv-1) and/or (iv-2) allow for an efficient removal of any remaining organic resin from the surface of the substrate, which has not been removed from said surface during previous method step (iii).

Preferably between step (iii) and step (iv-1) or between step (iii) and step (iv-2), a first rising step is performed:
(r-1) rinsing the chemical treated surface of the substrate obtained after step (iii) with a first rinsing solution, the first rinsing solution more preferably comprises distilled water.

Said first rinsing step allows for an effective treatment of the surface of the substrate after method step (iii) and before the subsequent mechanical treatment of step (iv-1) or the wet-chemical treatment of step (iv-2).

Preferably after step (iv-1) or after step (iv-2), the following second rising step is performed:
(r-2) rinsing the mechanically treated surface of the substrate obtained after step (iv-1) or the chemically treated surface of the substrate obtained after step (iv-2) with a second rinsing solution, the second rinsing solution more preferably comprises an aqueous acidic solution, which most preferably comprises sulfuric acid.

Said second rinsing step allows for an effective treatment of the surface of the substrate before the optional deposition of a conductive metal during step (v) and/or the optional electrolytic deposition of an additional coating metal during step (vi).

Preferably, step (iii) (or (iii-b)) and/or step (iv-2) is performed in the presence of ultrasonic waves provided by an ultrasonic emitter.

More preferably, during step (iii) (or (iii-b)) the ultrasonic parameter is 40 kHz for the ultrasonic device.

More preferably, during step (iv-2) the ultrasonic parameter is 40 kHz, 120 kHz for the ultrasonic device.

Preferably, step (iv-1) comprises contacting the chemical treated surface of the substrate with a rotating brush, wherein the rotating brush more preferably comprises nylon filaments with ceramic elements.

By applying such rotating brush after the chemical treatment of step (iii) (or (iii-b)), an effective mechanical removal of any remaining organic resin during the mechanical removal step (iv-1) can be ensured. In particular, the ceramic elements attached to the nylon filaments of the rotating brush allow for a particularly efficient removal of said organic resin.

Preferably, step (iv-1) is performed at room temperature, preferably from 20 °C to 25 °C.

Preferably, step (iv-1) is performed from 15 seconds to 5 minutes, more preferably from 30 seconds to 60 seconds.

Preferably, step (iv-1) is performed on a wet surface of the substrate.

Preferably, step (iv-2) is performed at a temperature from 55°C to 90°, more preferably from 65°C to 85°C.

Preferably, step (iv-2) is performed for a duration from 2 minutes to 10 minutes, more preferably for 12 minutes.

Preferably, the oxidizing agent used during step (iv-2) comprises sodium or potassium permanganate.

Preferably, the oxidizing agent is present in the oxidizing solution in an amount from 35 g/l to 70 g/I based on the total volume of the solution

Preferably, step (iv-2), optionally after a rinsing step, comprises at least two sub-steps (de):
wherein a (de-2) etching step using the oxidizing solution and a (de-3) reducing step are applied. These sub-steps may comprise applying of treatment solutions comprising treatment agents as shown below. Optionally, the sub-steps (de) comprise a (de-1) swelling step which is performed before the (de-2) etching step, wherein sub-step (de-1) comprises applying a first treatment agent, preferably a swelling agent, to the surface of the substrate, to obtain a swollen surface of the substrate.

Preferred is using only the (de-2) etching step and the (de-3) reducing step in step step (iv-2).

In one embodiment of the present invention, the sub-steps (de) comprise sub-steps (de-2) and (de-3) wherein sub-step (de-2) comprises applying a an oxidizing agent as second treatment agent, and more preferably potassium permanganate, to the surface of the substrate, to obtain an etched surface of the substrate, and wherein sub-step (de-3) comprises applying a third treatment agent, preferably a reducing agent, to the surface of the substrate, preferably to the etched surface of the substrate.

The sub-steps using the first treatment agent, second treatment agent and third treatment agent are preferably solved in aqueous treatment solutions.

Preferably, the first treatment agent, more preferably swelling agent, comprises organic solvents, which are most preferably selected as glycol ether and/or lactams, and penetrates into the exposed resin surface of through holes and BMVs. Most preferably, the swelling agent is selected as the commercially available Securiganth MV Sweller.

Preferably, the first treatment agent, more preferably swelling agent is applied at a concentration from 200 ml/l to 500 ml/l based on the total volume of the first treatment solution.

Preferably, the first treatment solution, comprising the swelling agent has a pH from 9.5 to 12.

Preferably, sub-step (de-1) is performed at a temperature from 55 °C to 85 °C, more preferably from 60 °C to 70°C.

Preferably, sub-step (de-1) is performed for a duration from 2 min to 15 min, preferably from 5 min to 10 min.

Preferably, the oxidizing solution as the second treatment solution is selected as an alkaline oxidizing solution comprising preferably comprising a potassium permanganate. Most preferably, the etching agent is selected as the commercially available Securiganth MV P-Etch .

Preferably, the oxidizing agent as a second treatment agent comprises potassium permanganate and is applied at a concentration from 35 g/l to 70 g/I based on the total volume of the oxidizing solution as second treatment solution.

Preferably, sub-step (de-2) is performed from a temperature of 55 °C to 90 °C, more preferably from 65 °C to 85°C, and most preferably at 75°C.

Preferably, sub-step (de-2) is performed for a duration from 2 min to 20 min, more preferably for 12 minutes.

Preferably, the third treatment agent, more preferably reducing agent comprises an acid, most preferably sulfuric acid or hydrochloric acid, a reducing agent capable to reduce metal leftovers from the previous step as citric acid, ascorbic acid hypophosphates, most preferably hydroxylammonium sulfate or hydrogen peroxide, and a polymer containing nitrogen atoms and/or positively charged nitrogen atoms. Most preferably, the reducing agent is selected as the commercially available Securiganth MV Reduction Conditioner.

Preferably, the third treatment agent, more preferably reducing agent, is applied at a concentration from 75 ml/l to 125 ml/l based on the total volume of the third treatment solution.

Preferably, the third treatment agent, more preferably reducing agent comprises from 80 ml/l to 100 ml/l of 50 w/w% sulfuric acid based on the total volume of the second treatment solution.

Preferably, sub-step (de-3) is performed from a temperature from 40 °C to 55 °C, more preferably from 40 °C to 50°C, and most preferably at 50°C.

Preferably, sub-step (de-3) is performed for a duration from 0.5 min to 5 min, preferably for 4 min.

Preferably, sub-step (de-3) is followed by a cleaning treatment step using a cleaning solution comprising a cleaning agent, which will comprise additives able to produce a clean metal surface onto the substrate by removing dirt or organic left overs by using at least one inorganic base, and/or organic base such as amines as ammonia or aliphatic amines and similars or an inorganic acid such as sulfuric acid, hydrochloric acid or organic acids such as sulfonic acids, carbonic acids, acetic acid, glycolic acid preferable together with additives which are able to reduce the surface tension of water as surfactants and optionally and more preferable with polymers able to adsorb on the before treated surfaces such as polymers with nitrogen at-oms and / or quaternized nitrogen atoms to form a conditioned surface. Most preferably, the cleaning agent is selected as the commercially available Securiganth MV Cleaner C1 V8, Securiganth MV Cleaner 902PF or Securignath MV Cleaner GFR-S1 or Cleaner Cupra Pro S2 EU.

Preferably, the cleaning agent comprises sodium hydroxide from 0 g/l to 30 g/l based on the total volume of the cleaning solution.

Preferably, the cleaning step is performed at a temperature from 30 °C to 70 °C, more preferably from 50 °C to 60°C, and most preferably at 60°C.

Preferably, the first cleaning step is performed for a duration from 0.5 min to 6 min, preferably from 1 min to 5 min.

### Optional step (v)

Preferably, method step (v) is performed by adding a metal activation composition in order to deposit e.g. a metal layer onto the wet-chemical-treated surface of the substrate, in particular onto the wet-chemical-treated surface of the solidified organic resin within the THs and/or BMVs, which can be deposited for example as metallic palladium or metallic copper as film or colloid or in ionic form with subsequent reduction. The metallic layer can be a pure metallic layer or can contain additional metals as metal alloy.

Preferably, the metal activation composition comprises e.g. at least one source of palladium ions or copper ions. Additionally, the solution may comprise other sources of metal ions, as sources of ruthenium ions, sources of rhodium ions, sources of palladium ions, sources of osmium ions, sources of iridium ions, sources of platinum ions, sources of copper ions, sources of silver ions, sources of nickel ions, sources of cobalt ions, sources of gold ions and mixtures thereof. The palladium ions or copper ions and said additional metal ions are being adsorbed on the wet-chemical-treated surface of said substrate and subsequently reduced or are being adsorbed as reduced metals e.g. colloids or particles, e.g. palladium colloids or copper colloids, wherein the palladium colloids may comprise tin or the copper colloids may comprise palladium.

Preferably, the activation composition is selected as the commercially available Neoganth MV Activator available by Atotech Deutschland GmbH & Co. KG.

Preferably, the activation composition may comprise carbon, conductive polymers, or metal ions or metal colloids containing e.g. copper, palladium, palladium-tin, for subsequent electrolytic direct metallization.

### Optional step (vi)

The electrolytic deposition of the additional coating metal according to method step (vi) allows for an effective deposition of metal coating on the substrate surface in order to obtain an electrolytic metal coated surface.

Preferably, the additional coating metal used during the electrolytic deposition step (vi) is selected from copper, nickel or alloys thereof, and more preferably is selected as copper.

Preferably, the electrolytic deposition step (vi) is performed by applying electrolytic copper plating baths, which for this purpose are well known in the art.

Preferably, said electrolytic copper plating baths comprise copper ions, an electrolyte (typically a strong acid such as sulfuric acid, fluoroboric acid or methanesulfonic acid), chloride ions, optionally one or more leveler, optionally one or more brightener and optionally one or more carrier. These compounds are known in the art and are disclosed for example in WO 2017/037040 A1 (page 21, line 1 to page 22, line 27).

Preferably step (vi) is performed for a duration from 30 min to 120 min, preferably for 90 min, and/or at a temperature from 10°C to 50°C, preferably at 32°C.

Preferably step (vi) is performed by applying a current density from 1 ASD to 25 ASD, preferably by applying a current density from 3 ASD to 15 ASD.

Preferably, method steps (i), (ii), (iii), (iv), (v) and/or (vi) are performed in a horizontal process or in a vertical process.

This allows for an effective adaptation of the method according to the first aspect to several manufacturing scenarios, thereby increasing the flexibility of said method.

According to the present invention, a horizontal or vertical process refers to the orientation of the substrate during the respective method steps (i), (ii), (iii), (iv), (v) and/or (vi).

During a horizontal process, the substrate, which in particular is formed as plate, is transferred through method steps (i), (ii), (iii), (iv), (v) and/or (vi) in a horizontal orientation, so that the lower side of the substrate faces towards the floor and the upper side of the substrate faces away from the floor. During the horizontal process, the substrate is preferably conveyed by a transport device to be processed in different treatment modules during the respective method steps (i), (ii), (iii), (iv), (v) and/or (vi).

During a vertical process, the substrate, which in particular is formed as plate, is transferred through method steps (i), (ii), (iii), (iv), (v) and/or (vi) in a vertical orientation, so that one lateral edge of the substrate faces towards the floor and the opposite lateral edge of the substrate faces away from the floor.

### Substrate

Preferably, the conductive through-holes (THs) and/or conductive blind micro vias (BMVs) of the dielectric substrate comprise a copper surface which is deposited onto the walls of the THs and BMVs within the dielectric substrate. The copper layer of the copper surface is conformal (thin and following the surface structure of the wall) deposited wherein the THs and BMVs are not filled with copper.

Preferably, after step (ii) the organic resin completely fills the conductive THs and conductive BMVs, and wherein during steps (iii), (iv-1) or (iv-2) the organic resin is not removed from the conductive THs and conductive BMVs.

Preferably, substrates according to the present invention comprise boards for HDI, MLB production and/or IC substrate articles with fine features, more preferably for horizontal plating applications comprising aspect ratios of through holes (THs) from 1:3 to 1:18 and/or blind micro vias (BMVs) from 1:0.5 to 1:2.3, or more preferably for vertical plating applications comprising aspect ratios of through holes (THs) from 1:3 to about 1:30 and/or blind micro vias (BMVs) from 1:1 or down to 1:1.15 to 1:2.3.

Preferably, the optional deposition of a conductive material according to method step (v) is performed with palladium species, conductive polymers, or carbon species as activation composition.

Preferably, the substrate, in particular a dielectric substrate having at least one dielectric surface to be treated, comprises organic polymers selected from resins and/or plastics, and blends thereof, wherein resins and plastics are more preferably selected from the group consisting of epoxy resin, isocyanate resin, bismaleimide triazine resin, phenylene resin, polyester, even more preferably selected from polyethylene terephthalate (PET), polyimide (PI), polytetrafluorethylene, acrylonitrile-butadiene-styrene (ABS) copolymer, polyamide (PA), polycarbonate (PC), liquid crystal polymer (LCP) as cyclic olefin copolymer (COC), Ajinomoto build-up films (ABF, ABF/epoxy-type substrate), or plastics made for photo-imageable dielectrics as well as mixtures and blends of the aforementioned, or a composite basing on a mixture of nonconductive filler particles as glass fillers and/or silica fillers and/or glass fabrics with said organic polymers. The substrate can also be a glass substrate or a silicon substrate.

The dielectric substrate as resin materials and plastic materials preferably comprise materials typically used in the electronics industry which are to be metallized. The material of the dielectric substrate is chemically different from the solidified organic resin derived from the organic paste.

Preferably, the organic polymers comprise polyimide resins or epoxy resins, wherein the polyimide resins can be modified by the addition of polysiloxane, polycarbonate, polyester, or the like.

Preferably, the epoxy resins can be a glass filler epoxy board material comprising a combination of the epoxy resin and glass filler, or the same modified to have a low thermal expansion and a high glass-transition temperature, constituting a high glass-transition temperature glass filler epoxy board material.

Preferably, the glass filler is selected from borosilicate glass, quartz glass, silica glass, and/or fluorinated glass. Silicon preferably includes polysilicon (including doped polysilicon such as p-doped polysilicon and n-doped polysilicon) and monocrystalline silicon, silicon oxide, silicon nitride as well as silicon oxynitride. The size of different filler has a range from 0.01 µm to 5 µm in diameter with preferably an average of 0.5 µm in diameter.

The glass fabrics are selected similar to glass fillers from borosilicate glass, quartz glass, silica glass and/or fluorinated glass. They are woven from individual glass fibers with diameters ranging from submicrometers to several micrometers in diameter. They give the printed circuit board mechanical stability and, together with the resins used, significantly influence the mechanical and thermal properties of the printed circuit board material.

Preferable the composite of the nonconductive layer is a build-up film, e.g. epoxy base materials. The size of the embedded glass filler has an average of 0.5 µm in diameter, with a maximum of 5.0 µm.

### Second aspect

According to a second aspect, the present invention is directed to a substrate with a metal coated surface obtained by a method according to the first aspect.

Preferably, the aforementioned regarding the method according to the first aspect of the present invention, preferably what is described as being preferred, applies likewise to the substrate of the second aspect of the present invention.

### Third aspect

According to a third aspect, the present invention is directed to a use of the non-aqueous composition according to the method of the first aspect for removing an organic resin from the surface of a dielectric substrate comprising a copper surface and conductive through holes (THs) and/or conductive blind micro vias (BMVs) for the manufacturing of an article comprising VIPPO (via-in-pad-plated over) structures.

Preferably, the aforementioned regarding the method according to the first aspect of the present invention, preferably what is described as being preferred, applies likewise to the use of the third aspect of the present invention.

### EXAMPLE

In the following example varying samples are provided to specify methods for removing an organic resin from a surface of a substrate.

In the following four samples (sample 1, sample 2, sample 3, sample 4) are described, which comprise a substrate used during the manufacturing process of a printed circuit board (PCB), respectively. The respective substrate is a FR-4 dielectric substate with through holes (TH), wherein copper layers are deposited on the upper side and the lower side of the substrate and also deposited onto the walls of the through holes (THs).

In a subsequent step, an epoxy-based organic paste is applied on the dielectric substate, to completely fill up the through holes (TH) and to also provide a 5 µm to 7 µm thick layer of said paste on top of the copper layers, which are deposited on the upper side and the lower side of the substrate.

Afterwards the organic paste applied to the respective substrate is thermally cured by applying a temperature of 150 °C for 45 minutes under vacuum. By said curing process, the epoxy-based organic paste is transferred into solidified organic epoxy resin, which fills up the through holes (TH) and covers the copper layers on the upper side and the lower side of the substrate.

Next, the respective dielectric substrate is chemically treated with a non-aqueous composition to remove the organic epoxy resin from the surface of the substrate, in order to obtain a chemical treated surface of said dielectric substrate.

The non-aqueous composition in respect to all four samples consist of:
a) 91 % by weight of benzyl alcohol;
b) 6.5 % by weight of 2-hydroxy-propionic acid;
c) 1.25 % by weight of at least one c10-c16-alkylbenzene sulfonic acid; and
d) 1.25 % by weight of 2,4,7,9-tetramethyldec-5-yne-4,7-diol.

### Sample 1:

According to sample 1, the non-aqueous composition is applied for 110 seconds at 80°C

### Sample 2:

According to sample 2, the non-aqueous composition is applied for 200 seconds at 80°C.

### Sample 3:

According to sample 3, the non-aqueous composition is applied for 10 minutes at 80°C.

Subsequently, the chemical treated surface of respective dielectric substrate according to all samples 1, 2 and 3 is treated with a first rinsing solution comprising distilled water for 60 seconds at 60 °C during a first rinsing step, wherein said first rinsing step was performed during the presence of ultrasonic waves.

Subsequently, the rinsed surface of the respective dielectric substrate is chemically treated according to sub-step (de-2) with the oxidizing solution, which comprises 70 g/L potassium permanganate as oxidizing agent, and 50 g/L sodium hydroxide, for 12 minutes at 75 °C. The treatment with the oxidizing solution allows for an effective removal of any remaining organic resin from the surface of the respective dielectric substrate.

Afterwards, a second rinsing step is performed by applying a second rinsing solution, which comprises an aqueous sulfuric acid solution for 1 minute at 50 °C.

Subsequently a reducing agent as a third treatment agent according to sub-step (de-3) is applied to the surface of the substrate to obtain a reduced surface of the substrate, wherein said reducing agent comprises 100 ml/L Securiganth MV Reduction Conditioner (hydroxylammonium-sulfate-based) and 35 ml/L sulfuric acid, for 4 minutes at 50°C. Afterwards a third rinsing step and a drying step is performed.

Afterwards, a cleaning agent is applied to the reduced surface of the substrate for 5 minutes at room temperature, wherein a fourth rinsing step is performed afterwards.

Afterwards during an etching step Securiganth Etch Cleaner C (potassium-caroate-based) was applied for 1 min at 25 °C, wherein a fifth rinsing step is performed afterwards.

To analyze the efficiency of the removal of the organic epoxy resin from the upper and lower surface of the respective dielectric substrate according to samples 1, 2 and 3 a subsequent plating step is performed, by immersing the respective substrate in an electrolytic nickel bath for 30 minutes at 40 °C while applying a voltage of approx. 3 ASD. Nickel was used for better visual inspection, but copper was deposited with the same results (not shown).

The resulting nickel metal coated surfaces of the respective substrates according to the samples 1, 2 and 3 are visually analyzed in respect to their surface properties, in particular in respect to the presence of any surface defects, such as stains, spots, exposed copper, etc., and are qualitatively ranked. In this respect "-" represents a poor surface quality, "0" represents an average surface quality, "++" represents a good surface quality, and "+++" represents an excellent surface quality.

The respective results are summarized in Table 1.

**Table 1: Optical properties of chemically treated substrate**

| **Sample** | **Optical properties** |
|---|---|
| 1 | ++ |
| 2 | +++ |
| 3 | +++ |

As can be derived from table 1, all three samples 1, 2 and 3 show uniform nickel plating with a minimal presence of any surface defects in sample 1, such as stains, spots, exposed copper, etc., thereby leading to the conclusion that the non-aqueous compositions allow for an efficient removal of organic epoxy resin from the respective surfaces of the dielectric substrate.

## Claims

1. A method for removing an organic resin from a copper surface onto a dielectric substrate comprising conductive through holes (THs) and/or conductive blind micro vias (BMVs), the method comprising the following steps:
(i) applying an organic paste to the dielectric substrate, in order to fill up the through holes (THs) and/or blind micro vias (BMVs) with the organic paste, wherein after step (i) at least a part of the surface of the dielectric substrate is covered by the organic paste;
(ii) curing the organic paste to transfer the organic paste into solidified organic resin, wherein after step (ii) at least a part of the surface of the dielectric substrate is covered by the organic resin;
(iii) chemical treating the dielectric substrate with a non-aqueous composition to remove the organic resin from the surface of the substrate, in order to obtain a chemical treated surface of the substrate, the non-aqueous composition comprising:
a) at least one high-boiling solvent at a concentration from 80 % by weight to 95 % by weight, preferred at a concentration from 81 wt.-% to 91 wt.-%, selected from the group, consisting of alcohols having general chemical formula R-OH, wherein R is a C₄-C₃₀ hydrocarbon group, wherein the high-boiling solvent has a boiling point of at least 100 °C,
b) at least one carboxylic acid at a concentration from 5 % by weight to less than 20 % by weight, preferred at a concentration from 4 % by weight to 9 % by weight, more preferred from 7 % by weight to 8 % by weight, preferably the at least one carboxylic acid is at least one hydroxy carboxylic acid,
c) at least one anionic aromatic surfactant at a concentration from 0,25 % by weight to less than 1.5 % by weight, preferred at a concentration from 0.5 % by weight to 1 % by weight, preferably
. selected from the group consisting of at least one c10-c16-alkylbenzene sulfonic acid and toluene-sulfonic acid, and
d) at least one non-ionic acetylenic diol - based surfactant at a concentration from 0.25 % by weight to less than 1.5 % by weight, preferred at a concentration from 0.5 % by weight to 1 % by weight, preferably selected from the group consisting of at least one c8-c12 alkyne-diol, more preferably is 2,4,7,9-tetramethyl-dec-5-yne-4,7-diol;
(iv-1) mechanically treating the chemical treated surface of the substrate obtained after step (iii) with an abrasion tool to remove remaining organic resin from the chemical treated surface of the substrate, in order to obtain a mechanically treated surface of the substrate; and/or
(iv-2) wet-chemical treating the chemical treated surface of the substrate obtained after step (iii) with an oxidizing solution comprising an oxidizing agent to remove remaining organic resin from the chemical treated surface of the substrate to obtain a wet-chemical treated surface of the substrate;
(v) optionally deposition of a conductive material, preferably electroless deposition of a coating metal, on the mechanically treated surface obtained after step (iv-1) or on the wet-chemical treated surface of the substrate obtained after step (iv-2), to obtain a conductive surface of the substrate;
(vi) optionally electrolytic deposition of an additional coating metal on the conductive surface of the substrate obtained after optional step (v) or on the mechanically treated surface of the substrate obtained after step (iv-1) or on the wet-chemical treated surface of the substrate after step (iv-2) in order to obtain an electrolytic metal coated surface; and
(vii) optionally structuring the electrolytic metal coated surface of step (vi) and electrolytic deposition of a solder pad, preferably tin solder pad, in order to obtain VIPPO (via-in-pad-plated over) structures.

2. The method according to claim 1, wherein step (iii) and/or step (iv-2) is performed in the presence of ultrasonic waves provided by an ultrasonic emitter.

3. The method according to claim 1 or 2, wherein step (iv-1) comprises contacting the chemical treated surface of the substrate with a rotating brush, wherein the rotating brush preferably comprises nylon filaments with ceramic elements.

4. The method according to any of the preceding claims wherein step (iii) is performed at a temperature from 60°C to 90° and preferably for a duration from 1 minute to 15 minutes.

5. The method according to any of the preceding claims, wherein step (iv-1) is performed at room temperature and preferably for a duration from 15 seconds to 5 minutes.

6. The method according to any of the preceding claims, wherein step (iv-1) is performed on a wet surface of the substrate.

7. The method according to any of the preceding claims, wherein step (iv-2) is performed at a temperature from 55°C to 90°, preferably from 65°C to 85°C.

8. The method according to any of the preceding claims, wherein step (iv-2) is performed for a duration from 2 minutes to 20 minutes, preferably for 12 minutes.

9. The method according to any of the preceding claims, wherein the oxidizing agent used during step (iv-2) comprises potassium permanganate.

10. The method according to any of the preceding claims, wherein the oxidizing agent used during step (iv-2) is present in the oxidizing solution in an amount from 35 g/l to 70 g/I based on the total volume of the solution.

11. The method according to any of the preceding claims, wherein step (iv-2), optionally after a rinsing step, comprises at least two sub-steps (de):
wherein a (de-2) etching step using the oxidizing solution and a (de-3) reducing step are applied.

12. The method according to claim 11, wherein the sub-steps (de) comprise a (de-1) swelling step which is performed before the (de-2) etching step.

13. An article with a metal coated surface obtained by a method according to any of the preceding claims 1 to 12.

14. Use of the non-aqueous composition comprising:
a) at least one high-boiling solvent at a concentration from 80 % by weight to 95 % by weight, preferred at a concentration from 81 wt.-% to 91 wt.-%, selected from the group, consisting of alcohols having general chemical formula R-OH, wherein R is a C₄-C₃₀ hydrocarbon group, wherein the high-boiling solvent has a boiling point of at least 100 °C;
b) at least one carboxylic acid at a concentration from 5 % by weight to less than 20 % by weight, preferred at a concentration from 4 % by weight to 9 % by weight, more preferred from 7 % by weight to 8 % by weight, preferably the at least one carboxylic acid is at least one hydroxy carboxylic acid;
c) at least one anionic aromatic surfactant at a concentration from 0.25 % by weight to less than 1.5 % by weight, preferred at a concentration from 0,5 % by weight to 1 % by weight, preferably the at least one anionic aromatic surfactant is selected from the group consisting of at least one c10-c16-alkylbenzene sulfonic acid and toluene-sulfonic acid; and
d) at least one non-ionic acetylenic diol - based surfactant at a concentration from 0.25 % by weight to less than 1.5 % by weight, preferred at a concentration from 0.5 % by weight to 1 % by weight, preferably selected from the group consisting of at least one c8-c12 alkyne-diol, more preferably is 2,4,7,9-tetramethyl-dec-5-yne-4,7-diol;
for removing an organic resin from the surface of a dielectric substrate comprising a copper surface and conductive through holes (THs) and/or conductive blind micro vias (BMVs) for the manufacturing of an article comprising VIPPO (via-in-pad-plated over) structures.
